**Europäisches Patentamt**

**European Patent Office**

**Office européen des brevets**

(19)

(11) **EP 1 505 722 A2**

(12) # EUROPEAN PATENT APPLICATION

(43) Date of publication:
**09.02.2005 Bulletin 2005/06**

(51) Int Cl.⁷: **H03B 5/32**

(21) Application number: **04018043.2**

(22) Date of filing: **29.07.2004**

| | |
|---|---|
| (84) Designated Contracting States:<br>**AT BE BG CH CY CZ DE DK EE ES FI FR GB GR HU IE IT LI LU MC NL PL PT RO SE SI SK TR**<br>Designated Extension States:<br>**AL HR LT LV MK**<br><br>(30) Priority: **01.08.2003 JP 2003285019**<br><br>(71) Applicant: **Seiko Epson Corporation**<br>**Shinjuku-ku, Tokyo 163-0811 (JP)** | (72) Inventor: **Takada, Yutaka**<br>**Suwa-shi Nagano-ken 392-8502 (JP)**<br><br>(74) Representative: **Hoffmann, Eckart, Dipl.-Ing.**<br>**Patentanwalt,**<br>**Bahnhofstrasse 103**<br>**82166 Gräfelfing (DE)** |

(54) **Oscillation circuit and radio communication device using the same**

(57) A power divider (5) and an SAW resonator (6) are provided in a feedback path (3) of an amplifier (2). The SAW resonator (6) is connected to the input side of the amplifier (2) and the power divider (5) is connected to the output side of the amplifier (2) so as to reduce the input power input to the SAW resonator (6) and to secure an output power output from an output terminal (4) of the power divider.

FIG. 1

EP 1 505 722 A2

**Description**

The present invention relates to an oscillation circuit having a surface acoustic wave resonator disposed in a feedback path of an amplifier, and a radio communication device using the same.

Recently, an oscillation circuit using a surface acoustic wave (SAW) resonator is applied for high frequency oscillation circuits having a frequency, for example, in the GHz range. However, the SAW resonator has a power handling capability that is lower than that of a dielectric filter. This causes the problem that a large power application of such oscillation circuit accelerates a deterioration of a comb-tooth-like electrode to result in a change of the oscillation frequency, a reduction of the oscillation power output and finally no oscillation.

In order to solve the problem, a method for manufacturing the SAW resonator for improving the power handling capability has been proposed in JP-A-10-75141. Here, an electrode composed of aluminum or an aluminum alloy is formed on a piezoelectric substrate. A layer composed of another element having a diffusion coefficient that is equal to or above of that of the aluminum is formed on at least a part of the electrode. Subjecting the layer composed of the other element to a heat treatment at a temperature higher than that at which the other element can diffuse, leads the another element to diffuse in a thickness direction of the electrode so as to form an electrode composed of an aluminum alloy including the other element.

In addition, a frequency converter equipped with a local oscillation part in which an amplifier is provided in a stage following an oscillation circuit so as to ensure the desired output power is proposed in JP-A-5-121949.

In addition, a quartz crystal oscillator where an oscillation inverter composed of a MOS-FET for oscillation is connected in parallel with a quartz crystal resonator is proposed in JP-A-10-173442. Here, the on-resistance of the MOS-FET configuring the oscillation inverter is set so as to control the power applied to the quartz crystal oscillator.

In the prior art of JP-A-10-75141, while the power handling capability of the SAW resonator itself can be improved, there is the unsolved problem that a continuous oscillating condition in which a large power is applied shortens the time over which the continuous oscillating can be maintained. As a result, the continuous oscillating condition cannot be maintained stably for long time.

In the prior art of JP-A-5-121949, while the output power can be increased since the oscillation output from the oscillator in the local oscillation part is amplified by an amplifier after multiplying by a quadrupling circuit, there is the unsolved problem that no measures are taken to enable the SAW resonator configuring the oscillation circuit to improve the power handling capability and to extend the life.

The prior art of JP-A-10-173442, including a resistor so as to reduce the power of the amplifier, controls the power applied to the quartz crystal oscillator, however, there is the unsolved problem that it cannot be applied to the oscillation circuit using the SAW resonator.

It is an object of the invention to provide an oscillation circuit and a radio communication device using the same that both are capable of maintaining a continuous oscillation condition for long time while reducing the power applied to the SAW resonator.

This object is achieved by an oscillation circuit as claimed in claim 1. Preferred embodiments of the invention are subject-matter of the dependent claims.

In the invention, since the SAW resonator is connected to the input side of the amplifier so as to supply the input power enabling the amplifier to keep a stable oscillation condition in a saturated condition, the SAW resonator is provided at an ending stage of the feedback path of the amplifier. This makes it possible to minimize the applied power that is input to the SAW resonator so as to keep the SAW resonator in a continuous oscillation condition for long time. In addition, since the power divider is connected to the output side of the amplifier, the output power of the amplifier can be output directly to the outside so as to achieve a large output power, thereby requiring no amplifier provided at the succeeding stage of the oscillation circuit for increasing the output power.

Preferred embodiments of the invention will now be described with reference to the accompanying drawings, in which:

FIG. 1      is a block diagram illustrating a first embodiment of the invention;

FIG. 2      is a diagram illustrating an input/output characteristic of an amplifier of the first embodiment;

FIG. 3      is a sectional view illustrating an SAW resonator of the first embodiment;

FIG. 4      is a block diagram illustrating a second embodiment of the invention;

FIG. 5      is a characteristic diagram illustrating a relationship between an elapsed time in a continuous oscillation and a frequency deviation;

FIG. 6      is a block diagram illustrating the case where the SAW resonator is connected to an output side of an amplifier;

FIG. 7      is a block diagram illustrating a third embodiment of the invention.

## First Embodiment

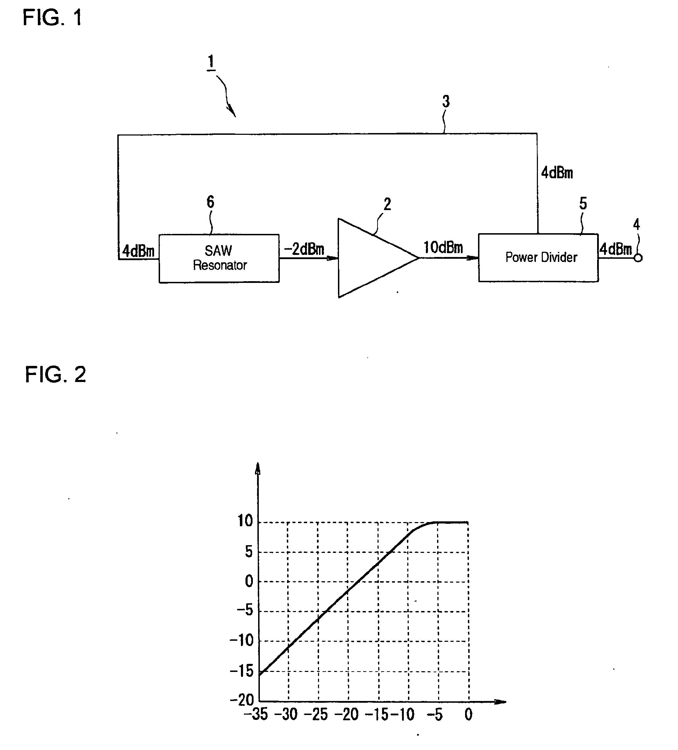

FIG. 1 is a block diagram illustrating a first embodiment of the invention. In FIG. 1, an oscillation circuit 1 includes an amplifier 2 for oscillation.

In a feedback path 3 from an output side of the amplifier 2 to its an input side, a power divider 5 and an SAW resonator 6 are provided. The power divider 5 is connected to the output side of the amplifier 2 and divides the output from the amplifier into two components to output one component to an output terminal 4 and provide the other component to the feedback path. The SAW resonator 6 is connected to the input side of the amplifier 2, and receives that other component as input. These blocks are connected each other so as to have their characteristic impedances matched, for example, each having a characteristic impedance of 50 Ω.

The amplifier 2 has an input/output characteristic as shown in FIG. 2 where the abscissa and the ordinate represent input power Pin (dBm) and output power Pout (dBm), respectively. The output power Pout increases linearly from minus 16 dBm to 8 dBm while the input power Pin increases from minus 35 dBm to minus 10 dBm. Then, the output power Pout increases slowly while the input power Pin increases to minus 5 dBm. Further, the output power Pout reaches approximately 10 dBm which is a saturated region for a steady oscillation condition, when the input power Pin reaches to minus 5 dBm and above.

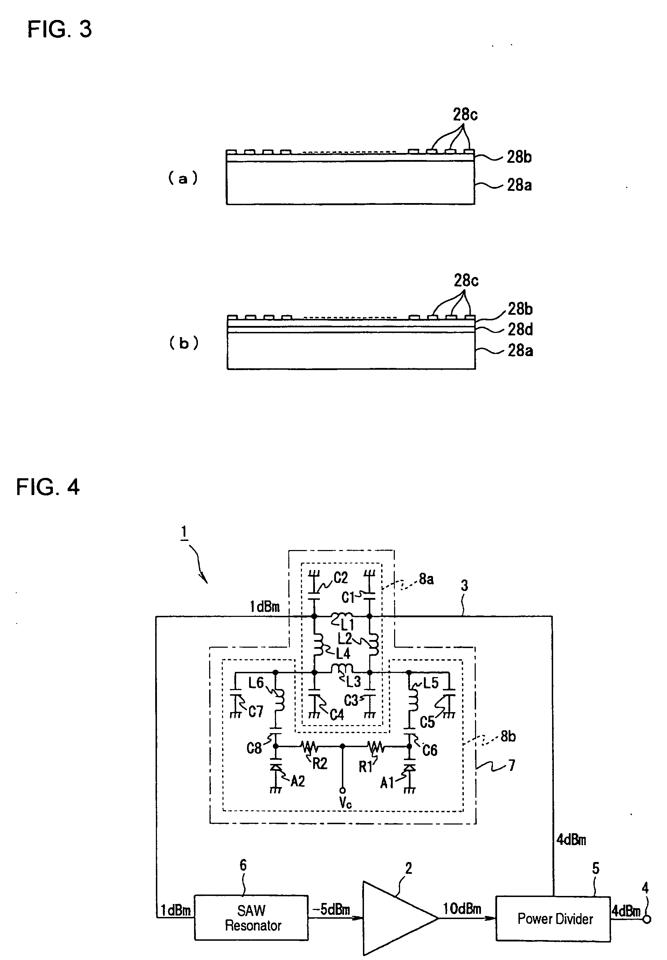

As shown in FIG. 3 (a), the SAW resonator 6 has a thin film piezoelectric layer 28b such like zinc oxide (ZnO), aluminum nitride (AIN), lead dioxide (PbO2), zirconium dioxide (ZrO2), titanium dioxide (TiO2) or the like formed on a diamond layer or a diamond-like carbon film layer 28a by a sputtering method or a vapor-phase synthesis method or the like, and a comb-teeth-like electrode 28c is formed on the thin film piezoelectric layer 28b. Alternatively, as shown in FIG. 3 (b), a semiconductive diamond layer 28d may be formed between the diamond or diamond-like carbon film layer 28a and the thin film piezoelectric layer 28b. The semiconductive diamond layer 28d is formed by introducing an impurity such like boron (B), aluminum (Al), phosphorous (P), sulfur (S) or the like, and/or by introducing a grid defect using an ion injection or an electron irradiation to an insulative diamond single crystal. Additionally, the semiconductive diamond layer may form the comb-teeth-like electrode 28c. In this way, forming the comb-teeth-like electrode on the diamond layer or the diamond-like carbon film layer enables the propagation velocity in a substrate to be large. This makes it possible to oscillate at higher frequency and to enlarge the electrode width of the SAW resonator as compared with another substrate material so as to improve the power handling capability. Smaller frequency changes due to a temperature change enable a higher accuracy oscillation circuit to be achieved.

The oscillation circuit 1 having the above-mentioned configuration includes a construction of the feedback type oscillator where a feedback circuit is connected to the amplifier 2.

If an input voltage Vi appears at the input side of the amplifier 2 having an amplification factor G, an output voltage Vo corresponding to the input voltage Vi multiplied by G (= Vi • G) appears at the output side. The output voltage Vo is returned to the input side as a feedback voltage Vf through the feedback circuit having a feedback ratio β. Here, Vf = Vo • β = Vi • G • β.

In this case, if the phase of the feedback voltage Vf is equal to that of the input voltage Vi, the feedback voltage Vf is larger than the input voltage Vi. This results in a positive feedback to generate the oscillation.

Let us assume the phase of the input voltage Vi to be θi, the phase of the feedback voltage Vf to be θf, the phase change by the amplifier 2 to be θG, and the phase change by the feedback circuit to be θβ. In order to generate an oscillation, it is required to satisfy the following relationship (1).

$$ Vi \cdot G \cdot \beta \cdot e^{j(\theta i + \theta G + \theta \beta)} \geq Vi \cdot e^{j(2\Pi + \theta i)} \qquad (1) $$

In the relation (1), the phase θi of the input voltage Vi is required to be the same when the input voltage Vi is input and when it is fed back to the input side after passing through the amplifier 2 and the feedback circuit. That is, the following relations must be satisfied:

$$ \theta G + \theta \beta = 2n\Pi; \qquad n=0, 1, 2, \cdots \qquad (2) $$

$$ G \cdot \beta > 1 \qquad (3) $$

Relation (2) shows the phase condition of the oscillation circuit. Relation (3) shows the amplitude or magnitude condition of the oscillation circuit.

Actually, if the feedback voltage Vf increase, the output voltage Vo of the amplifier 2 saturates to the steady condition where G • β = 1

Since the power divider 5 can allocate the output power of the amplifier 2 and output to the outside of the oscillating loop without disturbing the impedance in the oscillating loop, this enables a circuit to operate more stably to a load.

Next, the operation of the first embodiment will be described.

As above-mentioned, the input/output characteristic of the amplifier 2 is set such that the amplifier enters its saturation region at an input power Pin of minus 5 dBm; in the saturation region the output power Pout remains at approximately 10 dBm so as to be in the steady oscillation condition, as shown in FIG. 2.

In the steady oscillation condition, the output power Pout of 10 dBm that is output from the amplifier 2 is allocated to the output terminal 4 and the feedback circuit 3 by the power divider 5 so as to be output at 4 dBm respectively. Accordingly, an input power of 4 dBm is input to the input side of the SAW resonator 6. Subtracting an insertion loss of 6 dBm results in the input power Pin of the amplifier 2 of minus 2 dBm.

In this way, connecting the SAW resonator 6 in the feedback path 3 to the input side of the amplifier 2 results in an input power of 4 dBm being applied to the SAW resonator 6. This is much smaller than the input power of 10 dBm that would be applied were the SAW resonator provided at the output side of the amplifier 2. This is approximately 1/16 in terms of milliwatt.

This can minimize the power applied to a fine comb-teeth-like element having a size of sub-micron order in the SAW resonator 6 so as to prevent the electrode from deterioration, thereby maintaining a stable characteristic of the resonator for a long time. Consequently, an oscillation characteristic having little frequency aging and a high reliability can be achieved.

In addition, the power divider 5 connected to the output side of the amplifier 2 can output the gain of the amplifier 2 to the outside without waste. This increases the output power of the oscillation circuit so as to improve the signal/noise ratio (S/N), thereby enabling an oscillation characteristic having an excellent phase noise characteristic to be achieved.

Additionally, a high output power can be achieved by one oscillation circuit 1. This requires no buffer amplifier in a stage following the oscillation circuit in order to amplify the output power as in a conventional example, thereby enabling the size, the power consumption, and the cost to be reduced as a whole.

Further, the SAW resonator 6 includes a diamond substrate configured such that the thin film piezoelectric layer 28b is formed on the diamond layer or the diamond-like carbon film layer 28a and the comb-teeth-like electrode 28c is formed on the thin film piezoelectric layer 28b. This allows a larger propagation velocity in the substrate as compared with an SAW resonator employing a substrate made of a quartz crystal or a lithium tantalite, which makes it possible to oscillate a higher frequency (GHz range) and to enlarge the electrode width of the comb-teeth-like electrode so as to improve the power handling capability. In addition, a small frequency change due to a temperature change enables a higher accuracy oscillation circuit to be achieved.

In the above-mentioned first embodiment, while the case where the amplified output of the amplifier 2 is equally distributed to the feedback path and to the outside of the oscillating loop by the power divider 5 has been described (i.e. the power divider is an equal power divider), the embodiment is not limited to this. The amplified output of the amplifier 2 may be distributed at an arbitrary distribution ratio to the feedback path and to the outside of the oscillating loop by applying an unequal power divider.

**Second Embodiment**

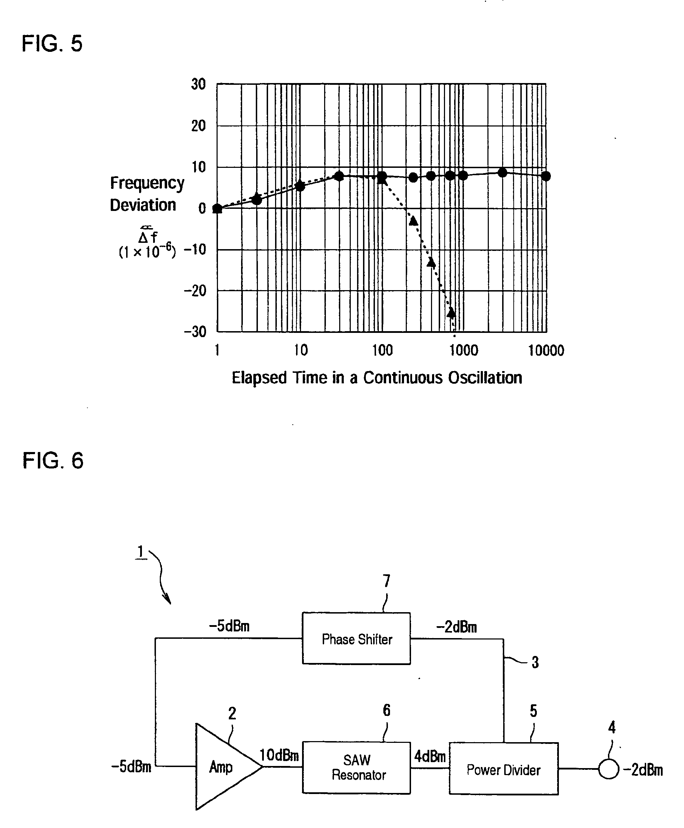

Next, a second embodiment of the invention will be described with reference to FIG. 4 and FIG. 5. In the second embodiment, the invention is applied to a voltage controlled oscillation circuit.

In other words, as shown in FIG. 4, the second embodiment includes the same configuration as that of FIG.1 of the first embodiment except that a phase shifter 7 for changing the phase in the oscillating loop by inputting a control signal from the outside is provided in the feedback path between the output terminal of the power divider 5 and the SAW resonator 6. Parts in GIG. 4 corresponding to those of FIG. 1 are denoted by the same reference sign and will not be described in detail again.

The phase shifter 7 includes a -3 dB 90 ° hybrid coupler 8a and an additional control part 8b. The hybrid coupler 8a includes capacitors C1 to C4 and coils L1 to L4. The coils L1 to L4 are connected so as to form a closed loop. The capacitor C1 and the output of the power divider 5 are connected to the node between the coils L1 and L2. The capacitor C3 is connected to the node between the coils L2 and L3. The capacitor C4 is connected to the node between the coils L3 and L4. The capacitor C2 and the input of the SAW resonator 6 are connected to the node between the coils L4 and L1.

The additional control part 8 includes a variable reactance circuit formed by capacitors C5 to C8, coils L5 and L6, resistors R1 and R2, and variable capacitors A1 and A2. The capacitor C5, the coil L5, the capacitor C6, the resistor R1, the resistor R2, the capacitor C8, the coil L6, and the capacitor C7 are connected in series in this order. The terminal between the capacitor C5 and the coil L5 is connected to the terminal between the capacitor C3 and the coil L2 of the hybrid coupler 8a. The terminal between the capacitor C7 and the coil L6 is connected to the terminal between the capacitor C4 and the coil L4 of the hybrid coupler 8a. The variable capacitor A1 is connected to the node between the capacitor C6 and the resistor R1. The variable capacitor A2 is connected to the node between the capacitor C8 and the resistor R2. An input terminal of a control voltage Vc is provided between the resistor R1 and the resistor R2.

Next, the operation of the second embodiment will be described.

If the amplifier 2 is saturated and the amplified output power is 10 dBm which is the same as in the first embodiment, the amplified output power is divided into two components of 4 dBm by the power divider 5. One component is output from the output terminal 4 and the other component is supplied to the phase shifter 7.

Since the phase shifter 7 includes the -3 dB 90° hybrid coupler 8a, a signal with a phase difference of 90° and a power 1 dBm, resulting from the 4 dBm component from the power divided of 4 dBm attenuated by 3 dBm due to the insertion loss of the hybrid coupler, is output to the SAW resonator 6.

Accordingly, the input power of 1 dBm to the SAW resonator 6 becomes the output power of -5 dBm after subtracting the insertion loss of 6 dBm in the SAW resonator 6 so as to be input to the amplifier 2. This leads the amplifier 2 to operate in the saturated region so as to maintain the oscillation at the desired high frequency.

Adjusting the control voltage Vc of the phase shifter 7 varies the phase shift amount of $\theta\beta$ shown in the above-described relation (1) such that the oscillation frequency of the oscillation circuit 1 changes so as to output an oscillation output of a desired frequency from the output terminal 4.

In the second embodiment, the SAW resonator 6 is also connected to the input side of the amplifier 2, and the power divider 5 is connected to the output side of the amplifier 2. This can reduce the input power of the SAW resonator 6 in the same manner as in the first embodiment. Accordingly, this also can minimize the power applied to the fine comb-teeth-like element having a size of sub-micron order in the SAW resonator 6 so as to prevent the electrode from deterioration, thereby maintaining a stable characteristic of the resonator for a long time. Consequently, an oscillation characteristic having little frequency aging and a high reliability can be achieved.

In addition, using the -3 dB 90° hybrid coupler and the variable reactance circuit accompanying it for the phase shifter 7 can achieve a large phase change with a low insertion loss and a low return loss. As a result, this makes it possible to take a wide frequency range of the voltage controlled oscillation circuit to enable a favorable frequency variation characteristic with respect to the control voltage Vc, thereby being able to be used as a standard oscillation circuit for a communication network system where a transmitting speed exceeds several gigabits per second.

In addition, the low insertion loss and the low return loss can minimize a circuit loss allowing to achieve an efficient voltage controlled oscillation circuit having little output fluctuation.

While keeping the voltage controlled oscillation circuit having the configuration of the above-mentioned second embodiment at a continuous oscillation condition, the relationship between the duration of the continuous oscillation and a frequency deviation $\Delta f$ (1 x $10^{-6}$) has been measured. As shown by the solid line in FIG. 5, the frequency deviation $\Delta f$ stays at approximately 8 x $10^{-6}$ even after 1000 hours. This has proved sufficiently sustainable for the continuous oscillation for a long time.

In contrast, if the SAW resonator 6 is provided at the output side of the amplifier 2 as shown in FIG. 6, the output power of the amplifier 2 of 10 dBm is input to the SAW resonator 6. The output power of the SAW resonator 6 becomes 4 dBm. This is equally divided such that the output power in and outside of the oscillating loop becomes -2 dBm respectively. Inputting the output power to the feedback path to the phase shifter 7 results in the output power of the phase shifter 7 being -5 dBm. This is fed back to the amplifier 2 to generate the oscillation.

However, in the configuration of FIG. 6, the input power of the SAW resonator 6 is 10 dBm. This is significantly higher than that of 4 and 3 dBm of the first and the second embodiment, respectively. The frequency deviation $\Delta f$ of the voltage controlled oscillation circuit having this configuration has been measured under the continuous oscillation. As shown by a broken line in FIG. 5, the frequency deviation $\Delta f$ began to change after 100 hours. After 1000 hours it exceeded -30 x $10^{-6}$. Hence, this does not allow a continuous oscillation for a long time.

In addition, in the configuration of FIG. 6, the output power from the output terminal 4 is -2 dBm. This is significantly smaller than the output power of 4 dBm of the first and the second embodiment. This causes a power shortage and the requirement to employ a buffer amplifier or the like in a succeeding stage in order to amplify the power.

In the second embodiment, while the -3 dB 90° hybrid coupler 8a is configured by a distributed constant type circuit, the embodiment is not limited to this. A concentrated constant type circuit may be employed instead.

Also, in the second embodiment, while the output of the phase shifter 7 is directly input to the SAW resonator 6, the embodiment is not limited to this. The output may be supplied via a frequency adjustment circuit having a filter configuration. This makes it possible to compact the configuration of the voltage controlled oscillation circuit and to ease the frequency adjustment.

**Third Embodiment**

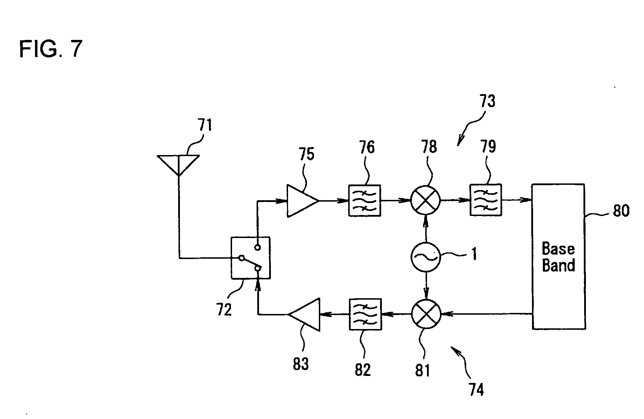

Next, a third embodiment of the invention will be described with reference to FIG. 7.

In the third embodiment, the oscillation circuit 1 of the invention is applied to a radio LAN device as a portable radio communication device. In other words, in the third embodiment, as shown in FIG. 7, a transmitting and receiving antenna 71 is connected to a transmitting and receiving changeover circuit 72. A receiving side output terminal of the changeover circuit 72 is connected to a receiving circuit 73. A transmitting side input terminal of the changeover circuit 72 is connected to a transmitting circuit 74.

The receiving circuit 73 comprises a low noise amplifier (LNA) 75, a band-pass filter 76, a mixer 78 and a band-pass filter 79. The band-pass filter 76 receives as input a receiving signal output from the changeover circuit 72. The mixer 78 receives as input an amplified output signal of the low noise amplifier 75. The mixer 78 receives as input a filtered output of the band-pass filter 76 and a local oscillating signal of several GHz output from the oscillation circuit of the above-mentioned first or second embodiment, and converts the filtered output down to become an intermediate frequency signal IF. The band-pass filter 79 receives as input the intermediate frequency signal IF output from the mixer 78. A filtered output of the band-pass filter 79 is input to a base band signal processing circuit 80 as receiving data.

Further, the transmitting circuit 74 comprises a mixer 81, a band-pass filter 82 and a power amplifier 83. The mixer 81 receives as input a transmitting signal from the base band signal processing circuit 80 and the local oscillating signal output from the above-mentioned oscillation circuit 1, and converts the transmitting signal up to be an output signal. The band-pass filter 82 receives as input the transmitting signal output from the mixer 81. The power amplifier 83 amplifies a filtered output of the band-pass filter 82 and outputs the amplified signal to the transmitting and receiving changeover circuit 72.

In the third embodiment, when the receiving signal does not exist in the base band signal processing circuit 80, the receiving data is processed as following. First, the changeover circuit 72 is changed over to the receiving circuit side to be a receiving state. The transmitting signal transmitted from another access point or the like and received by the antenna 71 is supplied to the low noise amplifier 75 via the changeover circuit 72. Then, the signal amplified by the low noise amplifier 75, is converted down to the intermediate frequency signal by the mixer 78. Finally, the receiving data filtered by the band-pass filter 79 are input to the base band signal processing circuit 80.

If a transmitting signal for another access point or the like exists in the base band signal processing circuit 80, the changeover circuit 72 is changed over to the transmitting circuit side so as to output the transmitting data to the mixer 81. Subsequently, the transmitting signal is up converted in the mixer 81 to be filtered through the band-pass filter 82. Finally, it is amplified by the power amplifier 83 so as to be supplied to the antenna 71 for transmission to another access point or the like via the changeover circuit 72.

For the radio LAN device, using the oscillation circuit 1 of the first or the second embodiment as the local oscillator enables the local oscillator to be smaller and having a longer life, which leads to enable the radio LAN device to be configured compact and to have a longer life.

In the third embodiment, the frequency is converted by one step, the embodiment is not limited to this. The case where the frequency is converted in multiple steps is applicable for this invention.

Also, in the third embodiment, while this invention was described as being applied to a radio LAN, the embodiment is not limited to this. A short-range wireless communication device carrying out radio communication by a frequency hopping method using an ISM (Industrial, Scientific and Medical) band of 2.4 GHz range, a mobile radio communication device such like a cellular phone or the like, a satellite broadcasting receiver, and another arbitrary communication device are possible applications as well.

## Claims

1. An oscillation circuit including:

    an amplifier (2),
    a surface acoustic wave resonator (6) provided in a feedback path (3) of the amplifier (2), and
    a power divider (5) outputting an oscillation signal in the feedback path (3) to an outside,

    **characterized in that**
    the surface acoustic wave resonator (6) is coupled to the input side of the amplifier (2) so as to supply an input power to saturate the amplifier (2); and
    the power divider (5) is coupled to the output side of the amplifier (2).

2. The oscillation circuit according to claim 1, further comprising a phase shifter (7) for changing the phase in the feedback path (3) in response to a control voltage.

3. The oscillation circuit according to Claim 1 or 2, wherein the surface acoustic wave resonator (6) includes a comb-teeth-like electrode (28c) formed on a diamond substrate (28d).

4. A radio communication device including the oscillation circuit (1) according to any one of Claims 1 through 3.

FIG. 1

FIG. 2

FIG. 3

(a)

28c
28b
28a

(b)

28c
28b
28d
28a

FIG. 4

1

C2
C1
8a
3

1dBm

L1
L2
L4
L3

L6
C7
C4
C3
C5
L5

C8
R2
R1
C6
8b

A2
A1
7

V<sub>c</sub>

4dBm

6
2
5
4

1dBm
SAW
Resonator
−5dBm
10dBm
Power Divider
4dBm

FIG. 5

Frequency Deviation $\overline{\Delta f}$ $(1 \times 10^{-6})$

Elapsed Time in a Continuous Oscillation

FIG. 6

FIG. 7